# FASCICULE DE BREVET EUROPEEN

(11) **EP 4 450 982 B1**
(45) Date de publication et mention de la délivrance du brevet: **19.11.2025**
(21) Numéro de dépôt: 24164427.7
(22) Date de dépôt: 19.03.2024
(51) Int. Cl.: G01R 27/18

(54) **PROCÉDÉ DE MESURE ET OHMMÈTRE DE BOUCLE MONO-TORE À COMPENSATION DE FLUX DE FUITE AC**
EINTOR-SCHLEIFEN-MESSVERFAHREN UND -METER MIT AC-LECKSTROMKOMPENSATION
METHOD FOR MEASURING AND MONO-TORE LOOP OHMIC METER WITH AC LEAKAGE FLUX COMPENSATION

(30) Priorité: 29.03.2023 FR 2303021
(43) Date de publication de la demande: 23.10.2024
(73) Titulaire: Chauvin Arnoux, 92600 Asnieres-sur-Seine (FR)
(72) Inventeur: LEGROS, Philippe, 92600 ASNIERES-SUR-SEINE (FR); ADAM, Jérôme, 92600 ASNIERES-SUR-SEINE (FR)
(74) Mandataire: Cabinet Beau de Loménie

(56) Documents cités:
- EP-A1- 1 566 644
- CN-A- 114 720 744
- CN-B- 110 007 133
- CN-B- 110 824 229
- FR-A1- 2 824 951
- FR-A1- 2 985 032
- IT-A1- PD20 090 005
- JP-A- 2001 066 329
- US-A1- 2014 021 939

## Description

### Domaine Technique

La présente invention se rapporte au domaine du contrôle des installations électriques et elle concerne plus particulièrement la mesure des résistances de terre au moyen d'ohmmètres de boucle.

### Technique antérieure

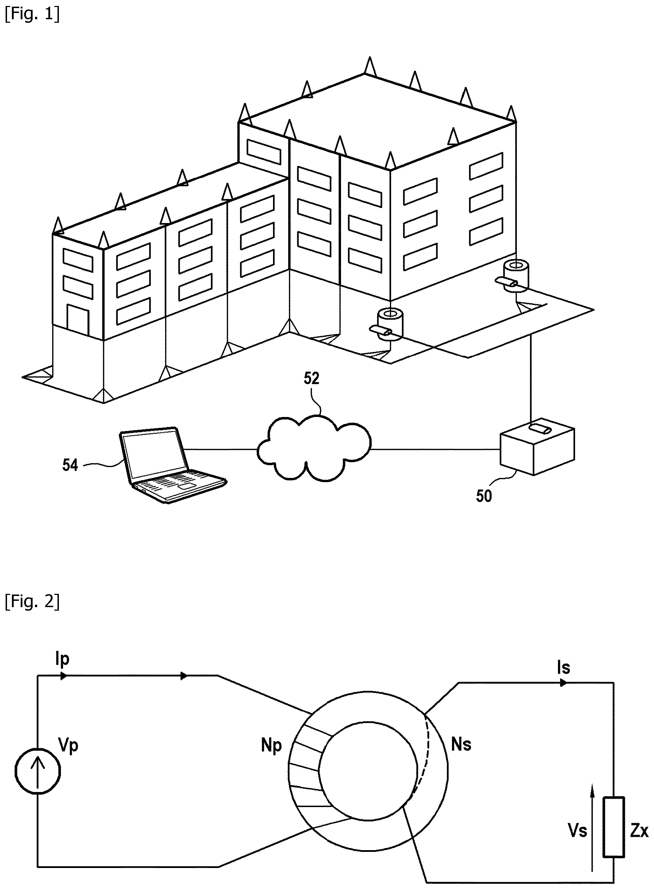

Les ohmmètres de boucle sont des appareils destinés à contrôler la conformité des raccordements à la terre d'installations électriques ou de bâtiments comme celui illustré à la figure 1. Ils sont particulièrement appropriés lorsque l'installation électrique dispose de multiples mises à la terre en parallèle formant plusieurs boucles de terre successives car la mesure ne nécessite pas de planter dans la terre des piquets auxiliaires ou d'ouvrir une liaison à la terre (barrette de terre par exemple) pour isoler l'installation électrique.

Classiquement, les ohmmètres de boucle recourent à l'utilisation de deux transformateurs magnétiquement isolés l'un de l'autre et enserrant le conducteur de raccordement à la terre, l'un pour injecter une tension par induction et l'autre pour mesurer le courant circulant dans la boucle. L'impédance du raccordement à la terre est alors déduite du rapport entre cette tension et le courant mesuré.

Toutefois, et comme le montre la figure 2, il est connu par le brevet EP1 566 644 B1 déposé au nom de la demanderesse un ohmmètre de boucle mono-tore qui permet de s'affranchir du transformateur de courant et de l'isolation magnétique entre les deux transformateurs en ne faisant appel qu'à un seul transformateur constitué d'un tore avec un enroulement primaire Np, utilisé simultanément pour l'injection de la tension et la mesure du courant circulant dans la boucle de terre, et un enroulement secondaire Ns avec une spire unique formée par le conducteur de raccordement à la terre dont l'impédance de boucle Zx est à mesurer. L'application d'une tension de consigne Vp aux bornes du primaire du transformateur fait circuler dans ce primaire un courant de mesure Ip qui induit, dans le conducteur enserré formant le secondaire, la tension secondaire Vs engendrant le courant secondaire Is = Vs / Zx circulant dans la boucle, m étant le rapport des nombres de tours de l'enroulement secondaire Ns et de l'enroulement primaire Np, soit m = Ns/Np.

Etant donné que la tension appliquée aux bornes du primaire Vp est une grandeur connue, si le transformateur était un transformateur parfait, il suffirait de mesurer le courant primaire Ip pour connaître l'impédance Zx. Mais, dans la réalité, le transformateur n'est pas parfait et a des pertes de flux magnétique, des pertes fer et cuivre et une perméabilité de circuit magnétique finie.

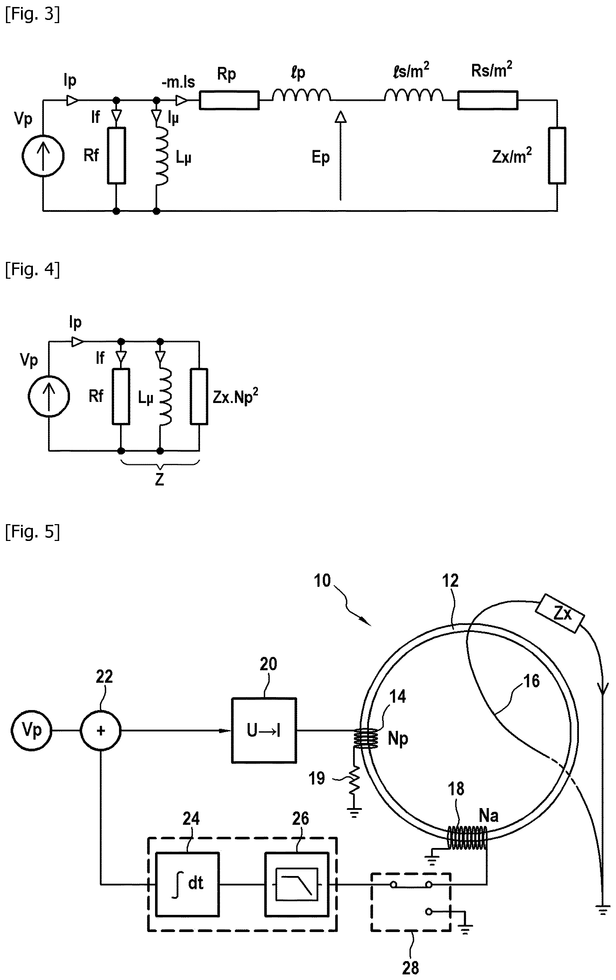

Aussi, la figure 3 illustre le schéma électrique équivalent du transformateur réel ramené au primaire sur lequel, Rf représente la résistance équivalente aux pertes fer du transformateur, Lµ l'inductance magnétisante du transformateur, c'est-à-dire l'image de la perméabilité non infinie du circuit magnétique, If et Iµ les composantes du courant magnétisant du transformateur, Rp la résistance de l'enroulement primaire, c'est-à-dire l'image des pertes cuivre, Ip l'inductance de fuite du primaire, c'est-à-dire l'image des pertes de flux magnétique, Rs la résistance de l'enroulement secondaire, Is l'inductance de fuite du secondaire et Ep la tension réelle générant le flux magnétique du transformateur.

Ce schéma équivalent peut se simplifier compte tenu que l'enroulement Ns étant constitué par la boucle dont on veut mesurer l'impédance Zx, il en résulte donc que Ns = 1 et Is devient négligeable et peut être considéré comme étant égal à zéro, de même que Rs, et que la valeur de Rp est négligeable devant ZxNp² d'où Rp ≈ 0.

Le schéma équivalent se réduit donc à la forme simplifiée illustrée sur la figure 4, ce qui permet d'écrire : Ip/Vp = 1/Z = 1/Rf + 1/jLµω + 1/ZxNp²
Où ω = 2nf, f étant la fréquence de la tension Vp.

La méthode de mesure de l'impédance de boucle décrite ci-dessus nécessite donc une connaissance permanente des valeurs de Rf et Lµ pour déterminer Zx. Ces deux valeurs sont obtenues à vide (boucle ouverte) avant l'installation du tore autour de la boucle dont l'impédance Zx est à mesurer.

Or, ces valeurs évoluent en fonction du niveau d'induction dans le tore qui dépend de la présence des courants parasites AC et DC circulant dans la boucle de mesure et qui doivent donc être compensés pour que les valeurs restent exploitables durant la phase de mesure et garantissent la précision de mesure recherchée sur la plage de mesure souhaitée.

### Exposé de l'invention

La présente invention a pour but principal de réduire l'influence de l'induction dans le tore (et principalement sur les pertes fer dont Rf est le modèle électrique) due à la présence de courant alternatif parasite AC dans la boucle de mesure (généralement à la fréquence du réseau et de ses harmoniques).

Ce but est atteint par un procédé de mesure d'une impédance de boucle Zx dans un ohmmètre mono-tore comportant un transformateur unique ayant un enroulement primaire de Np spires et un enroulement secondaire d'une spire unique formant une boucle de mesure d'impédance Zx, caractérisé en ce que, pour compenser une induction parasite produite par un courant de fuite AC circulant dans la boucle de mesure sans annuler un courant de mesure Ip générant une induction alternative de valeur moyenne constante pour la mesure de l'impédance de boucle Zx, ledit courant de mesure Ip est additionné à un courant opposé et proportionnel à l'induction parasite produite par le courant de fuite AC, pour être réinjecté dans l'enroulement primaire.

Cette induction peut être mesurée par différents procédés comme un capteur à effet Hall ou un enroulement de Rogowski, mais, selon une réalisation avantageuse, la mesure de l'induction parasite est issue d'une tension de sortie Ub délivrée aux bornes d'un second enroulement secondaire de Na spires du transformateur unique et ayant fait l'objet successivement d'un filtrage passe-bas et d'une intégration.

Ainsi, en mesurant, par quelque moyen que ce soit et de préférence par un enroulement secondaire, une grandeur dont l'amplitude est corrélée à l'induction résultant d'un courant de fuite AC, et en compensant les champs magnétiques associés en injectant un courant AC dans le primaire, on réduit l'influence de ce courant de fuite AC circulant dans la boucle de mesure sur les pertes fer.

De préférence, l'amplitude du courant injecté dans l'enroulement primaire est fixée par une résistance de shunt.

Avantageusement, la mesure de l'impédance de boucle est transmise à un boitier local de mesure via un réseau de communication filaire ou sans fil puis périodiquement à un serveur distant via un réseau Internet.

L'invention concerne également un ohmmètre de boucle mono-tore mettant en œuvre le procédé précité et comportant un transformateur unique ayant un enroulement primaire de Np spires et un enroulement secondaire d'une spire unique formant la boucle de mesure, caractérisé en ce que pour compenser une induction parasite produite par un courant de fuite AC circulant dans la boucle de mesure sans annuler un courant de mesure Ip générant une induction alternative de valeur moyenne constante pour la mesure de l'impédance de boucle Zx, le transformateur comporte un second enroulement secondaire de Na spires dont la tension de sortie Ub représentatif du courant de fuite AC est délivrée à un module de traitement fournissant une tension destinée à être additionnée à une tension alternative de mesure Vp dans un additionneur délivrant le courant à injecter dans l'enroulement primaire après passage dans un convertisseur tension-courant.

Avantageusement, le module de traitement de la tension de sortie du second enroulement secondaire consiste un filtre passe-bas suivi d'un intégrateur.

De préférence, l'ohmmètre mono-tore comporte en outre un commutateur d'activation/désactivation de la compensation du courant de fuite AC monté en sortie du second enroulement secondaire.

Avantageusement, le rapport entre le nombre de spires Np de l'enroulement primaire et le nombre de spires Na de l'enroulement au second secondaire est égal à un.

Selon un mode de réalisation préférentiel, le transformateur est réalisé sous la forme d'un capteur magnétique non-ouvrant laissé à demeure sur un conducteur de raccordement à la terre et l'impédance de boucle Zx est transmise périodiquement à un serveur distant via au moins un réseau de communication.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif et sur lesquels :
[Fig. 1] la figure 1 montre un ensemble de lignes électriques comportant des prises de terre reliant entre eux divers bâtiments,
[Fig. 2] la figure 2 montre schématiquement un ohmmètre de boucle mono-tore,
[Fig. 3] la figure 3 montre le schéma électrique équivalent d'un transformateur réel ramené au primaire,
[Fig. 4] la figure 4 montre le schéma simplifié du transformateur de la figure 3, et
[Fig.5] la figure 5 illustre un ohmmètre de boucle mono-tore à compensation de flux de fuite AC selon l'invention.

### Description des modes de réalisation

Le principe de l'invention repose sur une mesure de l'induction à l'aide d'un second enroulement secondaire pour compenser son influence sur Rf et Lµ. En utilisant ce second enroulement secondaire dont la tension en sortie est la dérivée du flux magnétique comme indicateur de flux AC, un courant proportionnel est réinjecté dans l'enroulement primaire pour compenser le flux AC perturbateur créé par le courant à mesurer circulant dans la boucle de mesure, sans avoir à interrompre la mesure.

On peut noter qu'un capteur à effet Hall ou fluxgate ou une boucle de Rogowski aurait aussi permis une telle mesure de l'induction parasite produite par le courant de fuite AC circulant dans la boucle de mesure.

La figure 5 illustre le schéma de principe de cette compensation du courant alternatif circulant dans la boucle de mesure (ci-après courant de fuite AC).

Le transformateur 10 est illustré par son tore 12, l'enroulement primaire 14 de Np spires, l'enroulement secondaire 16 à spire unique Ns formé par la boucle de mesure de l'impédance Zx et le second enroulement secondaire 18 de Na spires. De préférence, le rapport entre les nombres de spires à l'enroulement primaire Np et au second enroulement secondaire Na est égal à un sans toutefois que ce rapport ne soit limitatif (il peut en effet être supérieur ou inférieur à 1). Le courant injecté dans l'enroulement primaire 14 et dont l'amplitude est fixée par une résistance de shunt 19 est issu d'un convertisseur tension-courant 20, typiquement à amplificateur opérationnel, disposé en sortie d'un additionneur 22 destiné à ajouter un signal de compensation au signal de mesure (destiné à minimiser la valeur moyenne non nulle de l'induction alternative dans le tore) et recevant donc d'une part la tension alternative de mesure Vp correspondant à la tension utile pour mesurer Zx et d'autre part une tension Ucomp qui correspond à l'asservissement mis en place pour compenser le courant de fuite AC, et qui est prise en sortie d'un intégrateur 24 nécessaire pour retrouver un courant représentant le champ magnétique issu de ce courant de fuite AC et recevant lui-même le signal de sortie d'un filtre passe-bas 26 dont l'entrée est reliée aux bornes du second enroulement secondaire 18, de préférence au travers d'un commutateur à deux positions 28. Le filtre passe-bas 26 suivi de l'intégrateur 24 forme un module de traitement de la tension de sortie Ub.

On pourra noter qu'en mettant l'additionneur de tension avant le convertisseur, on évite d'avoir à recourir deux fois à la « fonction » de conversion tension-courant.

On pourra noter également que si fonctionnellement, additionneur et convertisseur ont été séparés, ils ne forment en pratique qu'un seul composant matériel.

Laissé à demeure sur un conducteur de raccordement à la terre, c'est dire avec un transformateur formant un capteur magnétique non-ouvrant, l'ohmmètre de boucle selon l'invention peut surveiller en permanence l'impédance de boucle Zx, et donc l'impédance de terre synonyme de qualité de la protection au point d'installation de ce capteur.

Comme le montre la figure 1, il peut comporter des moyens de communication propres en liaison via un réseau de communication (avantageusement sans fil de type 3G-5G ou Wifi notamment) ou filaire (Ethernet notamment) avec les moyens correspondant de communication d'un boitier local de mesure 50 pour transmettre régulièrement ses mesures d'impédance à un serveur distant 52 via le réseau Internet 54 par exemple, évitant ainsi le déplacement d'un opérateur pour assurer le contrôle de l'impédance Zx.

Avec l'invention, le courant de fuite AC est annulé sans annuler le courant de mesure injecté pour la mesure de l'impédance de boucle Zx. En effet, le courant de mesure Ip injecté sur l'enroulement primaire Np ne doit pas être impacté par l'asservissement du courant de fuite AC, d'où la présence du filtrage passe-bas dans le signal de compensation du courant de fuite AC pour que cette compensation n'annule pas le courant de mesure. Enfin, le signal de démagnétisation du tore étant à basse fréquence, le commutateur d'activation/désactivation de la compensation permet si nécessaire d'arrêter la compensation du courant de fuite AC.

## Revendications

1. Procédé de mesure d'une impédance de boucle Zx dans un ohmmètre mono-tore comportant un transformateur unique ayant un enroulement primaire de Np spires (14) et un enroulement secondaire d'une spire unique (16) formant une boucle de mesure d'impédance Zx, **caractérisé en ce que**, pour compenser une induction parasite produite par un courant de fuite AC circulant dans la boucle de mesure sans annuler un courant de mesure Ip générant une induction alternative de valeur moyenne constante pour la mesure de l'impédance de boucle Zx, ledit courant de mesure Ip est additionné à un courant opposé et proportionnel à cette induction parasite produite par le courant de fuite AC, pour être réinjecté dans l'enroulement primaire.

2. Procédé de mesure d'une impédance de boucle Zx selon la revendication 1, dans lequel la mesure de l'induction parasite est issue d'une tension de sortie Ub délivrée aux bornes d'un second enroulement secondaire de Na spires (18) du transformateur unique et ayant fait l'objet successivement d'un filtrage passe-bas (26) et d'une intégration (24).

3. Procédé de mesure d'une impédance de boucle Zx selon la revendication 1, dans lequel l'amplitude du courant injecté dans l'enroulement primaire est fixée par une résistance de shunt (19).

4. Procédé de mesure d'une impédance de boucle Zx selon la revendication 1, dans lequel la mesure de l'impédance de boucle est transmise à un boitier local de mesure (50) via un réseau de communication filaire ou sans fil puis périodiquement à un serveur distant (52) via un réseau Internet (54).

5. Ohmmètre mono-tore de mesure d'une impédance de boucle Zx, comportant un transformateur unique ayant un enroulement primaire de Np spires (14) et un enroulement secondaire d'une spire unique (16) formant la boucle de mesure, **caractérisé en ce que** pour compenser une induction parasite produite par un courant de fuite AC circulant dans la boucle de mesure sans annuler un courant de mesure Ip générant une induction alternative de valeur moyenne constante pour la mesure de l'impédance de boucle Zx, le transformateur comporte un second enroulement secondaire de Na spires (18) dont la tension de sortie Ub représentatif du courant de fuite AC est délivrée à un module de traitement (24, 26) fournissant une tension destinée à être additionnée à une tension alternative de mesure Vp dans un additionneur (22) délivrant le courant à injecter dans l'enroulement primaire (14) après passage dans un convertisseur tension-courant (20).

6. Ohmmètre mono-tore selon la revendication 5, dans lequel le module de traitement de la tension de sortie du second enroulement secondaire consiste un filtre passe-bas (26) suivi d'un intégrateur (24).

7. Ohmmètre mono-tore selon la revendication 5 ou la revendication 6, comportant en outre un commutateur (28) d'activation/désactivation de la compensation du courant de fuite AC monté en sortie du second enroulement secondaire (18).

8. Ohmmètre mono-tore selon l'une quelconque des revendications 5 à 7, dans lequel le rapport entre le nombre de spires Np de l'enroulement primaire (14) et le nombre de spires Na de l'enroulement au second secondaire (18) est égal à un.

9. Ohmmètre mono-tore selon l'une quelconque des revendications 5 à 8, dans lequel le transformateur est réalisé sous la forme d'un capteur magnétique non-ouvrant laissé à demeure sur un conducteur de raccordement à la terre et l'impédance de boucle Zx est transmise périodiquement à un serveur (54) distant via au moins un réseau de communication (52).

## Patentansprüche

1. Verfahren zum Messen einer Schleifenimpedanz Zx in einem Ohmmeter mit einem Ringkern, das einen einzigen Transformator umfasst, der eine Primärwicklung aus Np Windungen (14) und eine Sekundärwicklung aus einer einzigen Windung (16) aufweist, die eine Impedanzmessschleife Zx bildet, **dadurch gekennzeichnet, dass** zum Kompensieren einer Störinduktion, die von einem Wechselleckstrom erzeugt wird, der in der Messchleife fließt, ohne Aufheben eines Messstroms Ip, der eine Wechselinduktion mit konstantem Mittelwert zur Messung der Schleifenimpedanz Zx erzeugt, der Messstrom Ip zu einem Strom addiert wird, der entgegengesetzt und proportional zu dieser Störinduktion ist, die von dem Wechselleckstrom erzeugt wird, um erneut in die Primärwicklung eingespeist zu werden.

2. Verfahren zum Messen einer Schleifenimpedanz Zx nach Anspruch 1, wobei die Messung der Störinduktion von einer Ausgangsspannung Ub stammt, die an den Anschlüssen einer zweiten Sekundärwicklung mit Na Windungen (18) des einzigen Transformators abgegeben wurde und aufeinanderfolgend einer Tiefpassfilterung (26) und einer Integration (24) unterzogen wurde.

3. Verfahren zum Messen einer Schleifenimpedanz Zx nach Anspruch 1, wobei die Amplitude des in die Primärwicklung eingespeisten Stroms durch einen Shunt-Widerstand (19) festgelegt wird.

4. Verfahren zum Messen einer Schleifenimpedanz Zx nach Anspruch 1, wobei die Messung der Schleifenimpedanz über ein drahtgebundenes oder drahtloses Kommunikationsnetzwerk an ein lokales Messgehäuse (50) und dann periodisch über ein Internet-Netzwerk (54) an einen entfernten Server (52) übertragen wird.

5. Ohmmeter mit einem Ringkern zur Messung einer Schleifenimpedanz Zx, das einen einzigen Transformator umfasst, der eine Primärwicklung aus Np Windungen (14) und eine Sekundärwicklung aus einer einzigen Windung (16) aufweist, welche die Messschleife bildet, **dadurch gekennzeichnet, dass** zum Kompensieren einer Störinduktion, die von einem Wechselleckstrom erzeugt wird, der in der Messchleife fließt, ohne Aufheben eines Messstroms Ip, der eine Wechselinduktion mit konstantem Mittelwert zur Messung der Schleifenimpedanz Zx erzeugt, der Transformator eine zweite Sekundärwicklung mit Na Windungen(18) umfasst, deren Ausgangsspannung Ub, die für den Wechselleckstrom charakteristisch ist, an ein Verarbeitungsmodul (24, 26) abgegeben wird, das eine Spannung liefert, die dazu bestimmt ist, zu einer Messwechselspannung Vp in einem Addierer (22) addiert zu werden, der den nach dem Durchqueren eines Spannungs-Strom-Wandlers (20) in die Primärwicklung (14) einzuspeisenden Strom abgibt.

6. Ohmmeter mit einem Ringkern nach Anspruch 5, wobei das Modul zur Verarbeitung der Ausgangsspannung der zweiten Sekundärwicklung aus einem Tiefpassfilter (26), gefolgt von einem Integrator (24) besteht.

7. Ohmmeter mit einem Ringkern nach Anspruch 5 oder Anspruch 6, ferner umfassend einen Schalter (28) zur Aktivierung/Deaktivierung der Kompensation des Wechselleckstroms, der am Ausgang der zweiten Sekundärwicklung (18) montiert ist.

8. Ohmmeter mit einem Ringkern nach einem der Ansprüche 5 bis 7, wobei das Verhältnis zwischen der Anzahl der Windungen Np der Primärwicklung (14) und der Anzahl der Windungen Na der zweiten Sekundärwicklung (18) gleich eins ist.

9. Ohmmeter mit einem Ringkern nach einem der Ansprüche 5 bis 8, wobei der Transformator in der Form eines nicht öffnenden Magnetsensors ausgeführt ist, der auf einem Leiter zum Anschluss an die Erde belassen wird, und die Schleifenimpedanz Zx periodisch über mindestens ein Kommunikationsnetzwerk (52) an einen entfernten Server (54) übermittelt wird.

## Claims

1. A method for measuring a loop impedance Zx in a single-torus ohmmeter including a single transformer having a primary winding of Np coils (14) and a secondary winding of a single coil (16) forming a measurement loop of impedance Zx, **characterized in that**, to compensate for a stray induction produced by an AC leakage current circulating in the measurement loop without canceling a measurement current Ip generating an alternating induction of constant average value for the measurement of the loop impedance Zx, said measurement current Ip is added to a current opposite and proportional to this stray induction produced by the AC leakage current, to be re-injected into the primary winding.

2. The method for measuring a loop impedance Zx according to claim 1, wherein the measurement of the stray induction is derived from an output voltage Ub delivered across a second secondary winding of Na coils (18) of the single transformer and having been subjected successively to a low-pass filtering (26) and to an integration (24).

3. The method for measuring a loop impedance Zx according to claim 1, wherein the amplitude of the current injected into the primary winding is set by a shunt resistance (19).

4. The method for measuring a loop impedance Zx according to claim 1, wherein the measurement of the loop impedance is transmitted to a local measurement box (50) via a wired or wireless communication network then periodically to a remote server (52) via an Internet network (54).

5. A single-torus ohmmeter for measuring a loop impedance Zx, including a single transformer having a primary winding of Np coils (14) and a secondary winding of a single coil (16) forming the measurement loop, **characterized in that**, to compensate for a stray induction produced by an AC leakage current circulating in the measurement loop without canceling a measurement current Ip generating an alternating induction of constant average value for the measurement of the loop impedance Zx, the transformer includes a second secondary winding of Na coils (18) whose output voltage Ub representative of the AC leakage current is delivered to a processing module (24 - 26) providing a voltage intended to be added to an alternating measurement voltage Vp in an adder (22) delivering the current to be injected into the primary winding (14) after passage through a voltage-current converter (20).

6. The single-torus ohmmeter according to claim 5, wherein the module for processing the output voltage of the second secondary winding consists of a low-pass filter (26) followed by an integrator (24).

7. The single-torus ohmmeter according to claim 5 or 6, further including a switch (28) for activating/deactivating the compensation of the AC leakage current mounted at the output of the second secondary winding (18).

8. The single-torus ohmmeter according to any one of claims 5 to 7, wherein the ratio between the number of coils Np of the primary winding (14) and the number of coils Na of the winding to the second secondary (18) is equal to one.

9. The single-torus ohmmeter according to any one of claims 5 to 8, wherein the transformer is made in the form of a non-opening magnetic sensor left permanently on a ground connection conductor and the loop impedance Zx is transmitted periodically to a remote server (54) via at least one communication network (52).
